# EUROPEAN PATENT APPLICATION

(11) **EP 1 487 006 A1**
(43) Date of publication of application: **15.12.2004**
(21) Application number: 03707004.2
(22) Date of filing: 21.02.2003
(51) Int. Cl.: H01L 21/02, H01L 27/10, H01F 10/00, H01F 41/00, F27B 5/00, H01L 43/12

(54) **DEVICE AND METHOD FOR HEAT TREATMENT**

(30) Priority: 25.02.2002 JP 2002048629; 25.02.2002 JP 2002048634
(71) Applicant: Futek Furnace Inc., Yokohama-shi, Kanagawa 236-0004 (JP)
(72) Inventor: UENO, Hiroto, c/o FUTEK FURNACE INC., Yokohama-shi, Kanagawa 236-0004 (JP); MIWA, Kazuo, c/o FUTEK FURNACE INC., Yokohama-shi, Kanagawa 236-0 004 (JP); KOMURO, Kenji, c/o FUTEK FURNACE INC., Yokohama-shi, Kanagawa 236-0004 (JP); KANDA, Minoru, c/o FUTEK FURNACE INC., Yokohama-shi, Kanagawa 236-0004 (JP); KANADA, Wataru, c/o FUTEK FURNACE INC., Yokohama-shi, Kanagawa 236-0004 (JP)
(74) Representative: Greenwood, John David
(86) International application number: PCT/JP2003/001950
(87) International publication number: WO 2003/071589

(57) **Abstract**

A heat treatment device (1), comprising a treatment chamber (50) disposed adjacent to a heat treatment container (2) and capable of setting an internal space in a specified atmosphere and a moving means (10) acting on a holding means (3) for holding a treated material to move the treated material between the heat treatment container (2) and the treatment chamber (50).

## Description

### Technical Field

The present invention relates to a heat treatment apparatus and a heat treatment method for carrying out a heat treatment in a magnetic field. More specifically, the invention relates to a heat treatment apparatus and a heat treatment method for applying a heat treatment in a high magnetic field to a finely patterned material or magnetic material, particularly a magnetic material such as an MR film, a GMR film or a TMR film.

### Background Art

A magnetic film such as a thin film of an Fe-Ni, Pt-Mn or Co-Fe alloy or the like formed on a substrate, by sputtering or the like, which is a magnetic material used for a magnetic head, an MRAM (Magnetic Random Access Memory) which is one of non-volatile memories or the like can exhibit its magnetic properties by subjecting it to a heat treatment in a high magnetic field.

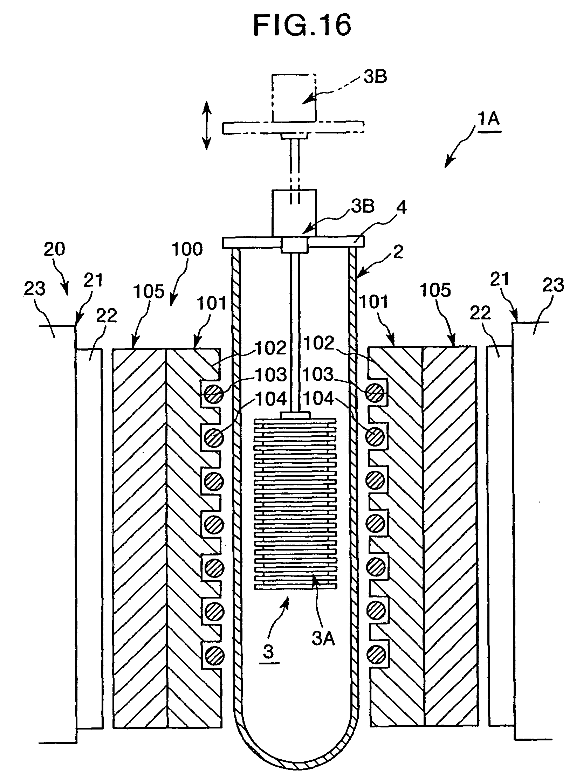

For this purpose, there is conventionally proposed a heat treatment apparatus in which an electric furnace, an induction heating furnace or the like is disposed to apply a heat treatment in a magnetic field formed with electromagnets or permanent magnets. A schematic configuration of a typical conventional heat treatment apparatus is illustrated in FIG. 16.

As shown in FIG. 16, a heat treatment apparatus 1A has a cylindrical vacuum vessel 2 serving as a heat treatment vessel, holding means 3 which holds an object to be treated in the vacuum vessel 2, and magnetic field generating means 20 arranged outside the vacuum vessel 2. The holding means 3 has a holder 3A which holds the object of treatment, and a holder supporting unit 3B which supports the holder 3A and has a lid member 4 for opening/closing an upper opening of the vacuum vessel 2.

The holder supporting unit 3B is arranged above the vacuum vessel 2, and the holder 3A holding the object to be heat-treated such as a magnetic material (hereinafter referred to as the "object of treatment") is charged therein by this supporting unit 3B.

The magnetic field generating means 20 is provided with a pair of electromagnets 21 arranged oppositely outside the vacuum vessel 2, and the electromagnet 21 has a magnetic core 22 and a coil 23.

Heating means 100 is provided between the outer surface of the vacuum vessel 2 and the end face of the magnetic core 22 of the electromagnet 21. Usually, the heating means 100 is spaced apart from the outer surface of the vacuum vessel 2 by a prescribed distance, and comprises electric heater 101 arranged so as to surround the outer periphery of the vacuum vessel 2. The electric heater 101 is formed, for example as shown in FIG. 16, by providing, for example a spiral groove 103 on the inner periphery of a heater support 102 made of bricks or ceramics arranged so as to surround the vacuum vessel 2, the inner periphery facing the outer periphery of the vacuum vessel. A heating wire such as a nichrome wire 104 is positioned in the groove 103. A heat insulator 105 such as alumina felt or bricks is arranged on the outer periphery of the heater support 102 so that heat of the heating means 100 is not transferred to the electromagnets 21.

The heat-treated object is taken out from the vacuum vessel 2. Then, a new object of treatment is held by the holder 3A, charged by the supporting unit 3B into the vacuum vessel 2, held, and subjected to the above-mentioned heat treatment. Subsequently, the heat treatment of the object of treatment is continued by batch treatment in the same procedure.

In the conventional art, the object of treatment is heat-treated in the heat treatment apparatus 1A usually at 150 °C to 500 °C. In some cases, heat treatment may be carried out at a high temperature of about 500 °C to 800 °C. When taking out the object of treatment after such a heat treatment in a high-temperature state from the vacuum vessel 2 to the open air, deterioration may be caused by oxidation or the like.

It is therefore necessary in the conventional art to retain the object of treatment after the heat treatment within the vacuum vessel 2 until the temperature thereof decreases to a level of about room temperature. This necessarily results in a longer single-batch treatment period. There is available a practice of cooling by providing a water-cooled jacket, but a long period of time of from 3 to 4 hours is generally required for reducing the temperature of the object of treatment after the heat treatment to about the room temperature.

Further, in the conventional heat treatment apparatus 1A, as shown in FIG. 16, the heat-treated object is taken out upward from the vacuum vessel 2. Then, the holder 3A holds a new object of treatment, and charges the same into the vacuum vessel 2 from above by means of the supporting unit 3B to carry out the above-mentioned heat treatment. Subsequently, the heat treatment of the object of treatment is continued by batch treatment in the same procedure.

In the conventional heat treatment apparatus 1A, as described above, since a magnetic material or the like as the object of treatment has a large weight, the upper end of the vacuum vessel 2 has an opening, and the object of treatment is charged into, and discharged from, the vacuum vessel 2 through this opening.

According to the result of studies and experiments carried out by the present inventors, although the heat treatment apparatus 1A having the above-mentioned configuration is configured so as to carry out a heat treatment in a dust-free environment, deposition of dust onto the object of treatment was observed.

Further studies were carried out to solve this problem, and the result revealed the followings. The conventional heat treatment apparatus 1A has the supporting unit 3B, and in addition, although not shown in FIG. 16, conveying means such as a lift mechanism having a driving motor for vertically moving the supporting unit 3B, arranged above the object of treatment held by the holder 3A and the vacuum vessel 2. Upon operation, therefore, dust produced from the supporting unit 3B and the conveying means adheres directly to the object of treatment, or further intrudes into the vacuum vessel 2 to deposit onto the object of treatment during the heat treatment.

In order to prevent generation of dust from the holder supporting unit 3B and the conveying means, therefore, it is necessary to extensively make efforts to eliminate dust for the entire apparatus, and this requires a more complicated and larger-scaled apparatus structure. This results in a larger space for installation of the apparatus and in a lower degree of freedom in the apparatus arrangement.

A primary object of the present is therefore to provide a heat treatment apparatus and a heat treatment method which permit reduction of single-batch treatment period, and increase in the throughput of the object of treatment.

Another object of the present invention is to provide a heat treatment apparatus and a heat treatment method which make it difficult for dust to adhere to the object of treatment.

Still another object of the present invention is to provide a heat treatment apparatus and a heat treatment method which permit reduction of the installation space of the apparatus and improvement of the degree of freedom of apparatus arrangement.

### Disclosure of Invention

The aforementioned objects of the present invention are achieved by the heat treatment apparatus and the heat treatment method of the invention.

In summary, a first aspect of the present invention provides a heat treatment apparatus comprising holding means which holds an object of treatment, a heat treatment vessel which houses the object of treatment held by said holding means, heating means which heats the object of treatment, and a magnetic field generating means which impresses a magnetic field onto the object of treatment, wherein the heat treatment apparatus further comprises:
a treatment chamber, arranged adjacent to the heat treatment vessel, in which an internal space can be set to contain a prescribed atmosphere; and
conveying means which acts on the holding means to cause the object of treatment to move between said heat treatment vessel and said treatment chamber. According to an embodiment of the present invention, said heating means and said magnetic field generating means are arranged so as to surround said heat treatment vessel.

According to the second aspect of the present invention, there is provided a heat treatment method for heat-treating an object of treatment in a magnetic field by using the above-mentioned heat treatment apparatus comprises:
(a) a step of housing the object of treatment in said heat treatment vessel;
(b) a step of setting the interior of said heat treatment to contain a prescribed atmosphere to carry out the heat treatment in the magnetic field ; and
(c) a step of conveying the heat-treated object of treatment to said treatment chamber set to contain a prescribed atmosphere.

According to an embodiment of the above-mentioned first and second aspect of the present invention, the object of treatment is deteriorated in an open-air atmosphere at a heat treatment temperature, and said treatment chamber is set to contain a nonoxidizing atmosphere.

According to another embodiment of the above-mentioned first and second aspects of the present invention, the nonoxidizing atmosphere in said treatment chamber is a nitrogen gas or an argon gas atmosphere. The atmosphere in the treatment chamber may be in vacuum.

According to still another embodiment of the above-mentioned first and second aspects of the present invention, said treatment chamber is set at a prescribed temperature. In this case, the prescribed temperature of the treatment chamber may be the room temperature.

According to further another embodiment of the above-mentioned first and second aspects of the present invention, the treatment chamber may be arranged above, below, or on one side of the heat treatment vessel.

According to a third aspect of the present invention, there is provided a heat treatment apparatus comprising holding means which holds an object of treatment, a heat treatment vessel which houses the object of treatment held by said holding means, heating means which heats the object of treatment, and magnetic field generating means which impresses a magnetic field on the object of treatment, wherein the heat treatment apparatus further comprises:
a dust-free chamber, arranged below said heat treatment vessel, in which an opening formed at the lower end of said heat treatment vessel opens; and
conveying means, arranged in the dust-free chamber, which acts on said holding means to cause the object of treatment to move between said heat treatment vessel and said dust-free chamber.

According to an embodiment of the above-mentioned third aspect of the present invention, said heat treatment vessel is a vacuum vessel evacuated by closing an opening, and said conveying means is arranged at a position below the opening of said vacuum vessel.

According to another embodiment of the third aspect of the present invention, said conveying means has a movable portion positioned below the object of treatment arranged in said dust-free chamber.

According to still another embodiment of the third aspect of the present invention, said heating means and the magnetic field generating means are arranged so as to surround said heat treatment vessel.

According to further another embodiment of the third aspect of the present invention, at least said magnetic field generating means is separable from said heat treatment vessel.

According to a fourth aspect of the present invention, there is provided a heat treatment method for heat-treating an object of treatment in a magnetic field by using the above-mentioned heat treatment apparatus comprises:
(a) a step of housing the object of treatment in said holding means;
(b) a step of charging the object of treatment into said heat treatment vessel from below tocarry out the heat treatment in the magnetic field; and
(c) a step of taking out the heat-treated object of treatment from said heat treatment vessel by conveying the same downward into said dust-free chamber.

### Brief Description of the Drawings

FIG. 1 is a schematic sectional front view of the configuration of an embodiment of the heat treatment apparatus of the present invention;
FIG. 2 is a schematic sectional plan view of the configuration of an embodiment of the heat treatment apparatus of the present invention;
FIG. 3 is a schematic sectional side view of the configuration of an embodiment of the heat treatment apparatus of the present invention;
FIG. 4 is a schematic sectional side view of the configuration of FIG. 1 cut along the line 4-4;
FIG. 5 is a partial sectional view illustrating the layout relationship of a vacuum vessel, heating means and an electromagnet;
FIG. 6 is a partial enlarged sectional view of heating means;
FIG. 7 is a perspective view illustrating the whole view of an embodiment of the water-cooled jacket;
FIG. 8 is a sectional view of an electric heater;
FIG. 9 is a perspective view illustrating the method of installing the electric heater;
FIG. 10 is a schematic configuration diagram of another embodiment of the heat treatment apparatus of the present invention;
FIG. 11 is a schematic configuration diagram of another embodiment of the heat treatment apparatus of the present invention;
FIG. 12 is a schematic sectional front view of configuration of another embodiment of the heat treatment apparatus of the present invention;
FIG. 13 is a schematic sectional plan view of configuration of another embodiment of the heat treatment apparatus of the present invention;
FIG. 14 is a schematic sectional side view of configuration of another embodiment of the heat treatment apparatus of the present invention;
FIG. 15 is a partial sectional view illustrating the layout relationship of a vacuum vessel, heating means and an electromagnet; and
FIG. 16 is a schematic sectional view of configuration of a conventional heat treatment apparatus.

### Best Mode for Carrying Out the Invention

The heat treatment apparatus and the heat treatment method of the present invention will now be described further in detail with reference to the drawings.

### First Embodiment

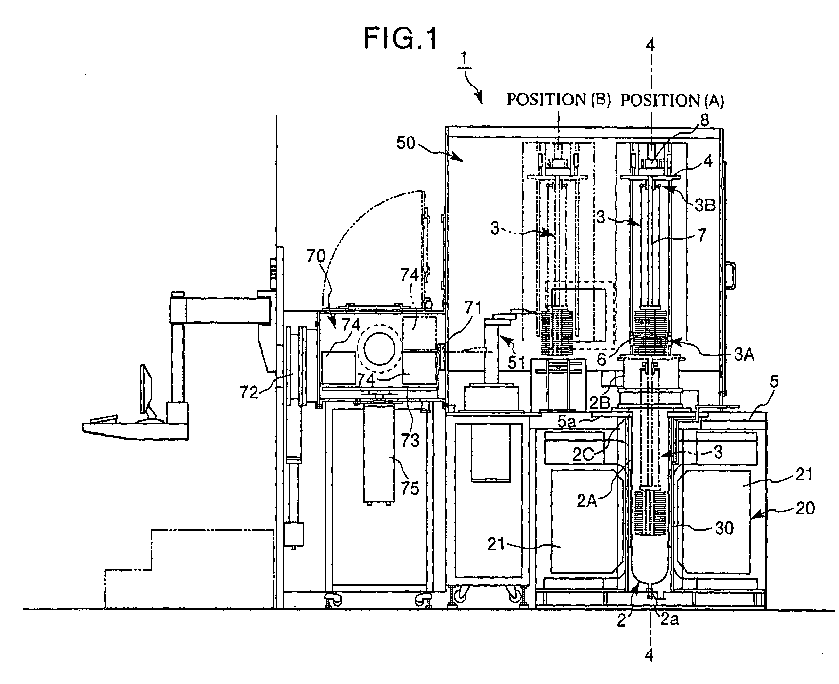

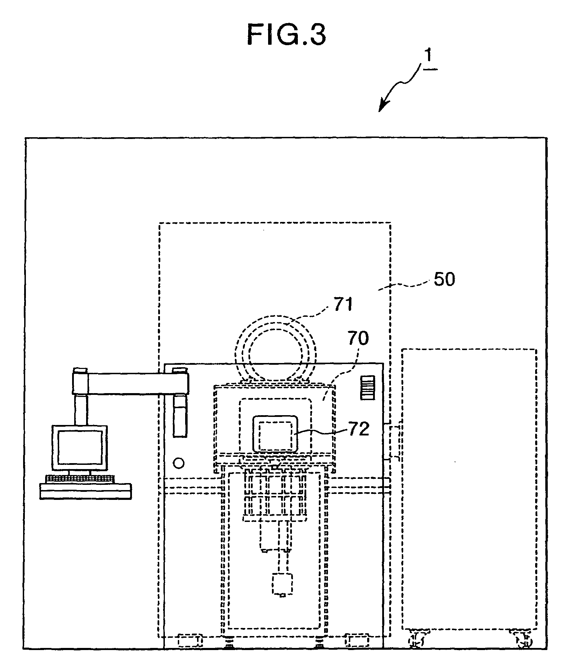

FIGS. 1 to 4 illustrate a schematic overall configuration of an embodiment of the heat treatment apparatus 1 of the invention.

According to this embodiment, the heat treatment apparatus 1 has a vacuum vessel 2 serving as a heat treatment vessel, holding means 3 which holds an object of treatment in the vacuum vessel 2, and magnetic field generating means 20 arranged outside the vacuum vessel 2, as in the conventional heat treatment apparatus 1A. The holding means 3 has a holder 3A which holds the object of treatment, and a holder supporting unit 3B which supports this holder 3A.

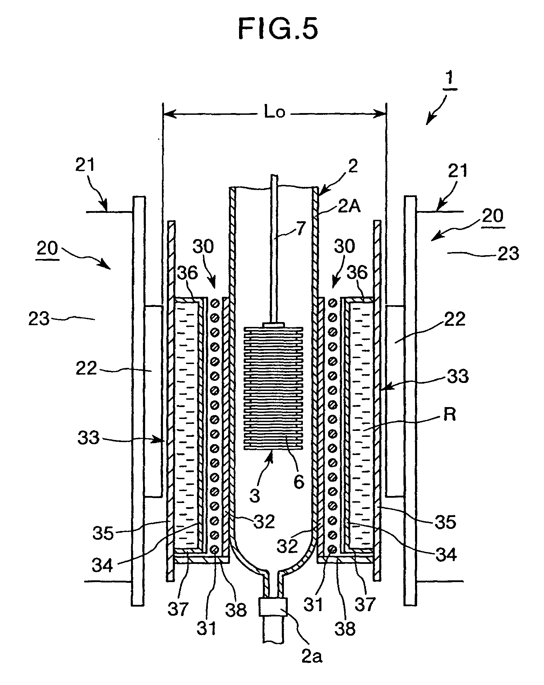

As is understood well by referring also to FIG. 5, in this embodiment, the vacuum vessel 2 is a stepped cylindrical container comprising a vessel main body 2A having a smaller diameter, and a vessel attachment section 2B having a larger diameter formed integrally with the upper portion of the vessel main body 2A. In this embodiment, the lower end of the vessel main body 2A is connected to a conduit for introducing a nonoxidizing gas via a valve 2a. However, the lower end of the vessel main body 2A is substantially a closed end, and the upper end of the vessel attachment section 2B is open.

In this embodiment, the upper end of the vessel is closely sealed by attaching a lid member 4 of the holder supporting unit 3B to the opening at the upper end of the vessel. An annular shoulder 2C formed between the vessel main body 2A and the vessel attachment section 2B of the vacuum vessel 2 is mounted on a vessel placing section 5a of the lower structure 5, and the vacuum vessel 2 is held there.

The vacuum vessel 2 should preferably be made of ceramics such as quartz glass for its stability during rapid cooling. In this embodiment, as described later in detail, heating in vacuum by heating means 30 is accomplished mainly by radiation heat. The quartz glass should therefore preferably be an optically transparent one. The vacuum vessel 2, which may have a thickness within a range of from 2 to 6 mm, has a thickness of 3 mm in this embodiment.

The holder 3A comprises about 30 trays 6 for mounting a substrate having a diameter of from about 100 to 200 mm and having, for example an Fe-Ni alloy film formed by sputtering. The trays 6 are supported by a supporting shaft 7, the upper end of which is suspension-supported by the holder supporting unit 3B.

The holder supporting unit 3B should preferably rotatably hold the holder 3A so that the direction of the object of treatment held by the holder 3A can be changed relative to the magnetic field direction. In this embodiment, therefore, a driving motor 8 is attached to the holder supporting unit 3B so that the supporting shaft 7 of the holder 3A can be rotation-driven.

The vacuum vessel 2 can be maintained in a prescribed vacuum state by evacuating the interior of the vacuum vessel 2 by means of a vacuum pump (not shown) communicating with the upper end of the vacuum vessel, after attaching the holder supporting unit 3B to the upper end of the vacuum vessel. For example, when the object of treatment is a magnetic metal thin film, the object of treatment should preferably be heat-treated in vacuum, or more specifically, in a vacuum of up to 1 Pa to avoid oxidation of the metal thin film. Or preferably, the interior of the vacuum vessel 2 is filled with a nonoxidizing gas such as nitrogen gas or argon gas to achieve a nonoxidizing gas atmosphere in the vacuum vessel 2.

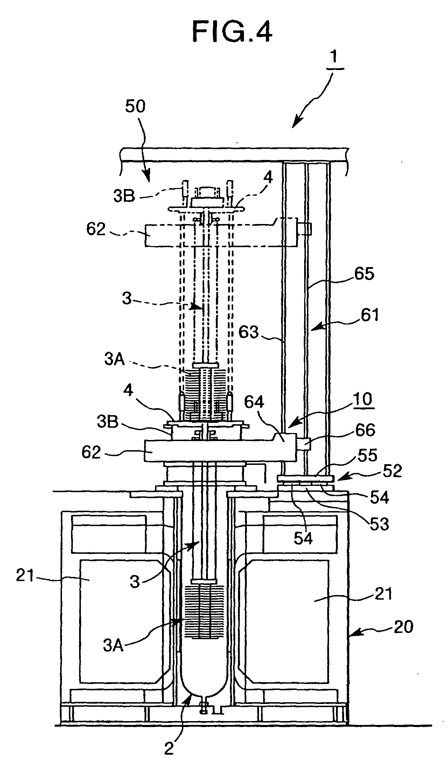

The holder supporting unit 3B is arranged at the upper end of the vessel. The holder 3A can be moved, together with the holder supporting unit 3B, by a lift mechanism 10 (see FIG. 4) serving as conveying means upward outside the vessel 2. In this state, therefore, it is possible to mount the object to be heat-treated such as a magnetic material onto the holder 3A, or remove the same from the holder 3A. The lift mechanism 10 serving as the conveying means will be described later in detail.

The magnetic field generating means 20 is provided with a pair of electromagnets 21 oppositely arranged, and each electromagnet 21 has, as shown in FIG. 5, a magnetic core 22 and a coil 23. According to this embodiment, as described later in detail, the heating means 30 arranged between the vacuum vessel 2 and the magnetic core 22 may have a smaller thickness, and it is therefore possible to reduce the distance between the magnetic cores 22 and 22 of the electromagnets 21 in pair. Therefore, the electromagnet 21 itself can be downsized. According to this embodiment, furthermore, since the magnetic core 22 is not heated, low thermal resistance materials can be used. In this embodiment, therefore, it is possible to use a magnetic field density produced with the magnetic field generating means 20 of at least 0.05 tesla, or particularly, within a range of from about 0.1 to 5 tesla. In this embodiment, the distance (LO) between the magnetic cores 22 (see FIG. 5) is 300 mm.

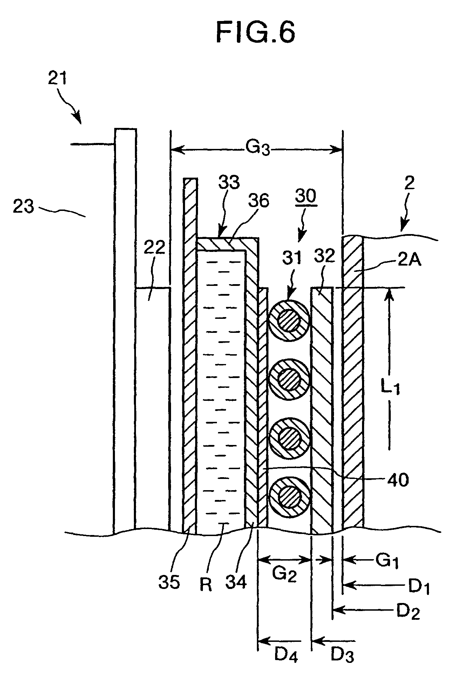

As is understood by referring also to FIG. 6, the thin-shaped heating means 30 is provided between the outer surface of the vessel main body 2A of the vacuum vessel 2 and the end face of the magnetic core 22 of the electromagnet 21. There is provided an electric heater 31 based on electric-resistance heating as the heating means 30. The heating means is not limited to this. Such heating means 30 is preferable as compared with induction heating means requiring an expensive power source because of the low cost.

More specifically, the heating means 30 has an electrically insulating inner cylinder 32 arranged so as to surround the outer periphery of the vacuum vessel main body 2A, and a water-cooled jacket forming a fluid cooling section 33 spaced apart from the inner cylinder 32 by a prescribed distance. The inner cylinder 32 can be manufactured from a quartz glass tube having a thickness of from 2 to 6 mm. A gap (G1) of from 2 to 4 mm is provided between the inner cylinder 32 and the outer periphery of the vacuum vessel main body 2A. In this embodiment, in which the vacuum vessel main body 2A has an outside diameter (D1) of 240 mm, the inner cylinder 32 has an inside diameter (D2) of 245 mm. The inner cylinder 32 has an axial length (L1) of 450 mm.

The water-cooled jacket 33 is a cylinder having a dual tube structure with an inner wall 34 and an outer wall 35, and the upper end and the lower end thereof are closed by an upper wall 36 and a lower wall 37, respectively. In this embodiment, as shown in FIG. 5, the outer wall 35 is extended below the lower wall 37 in the axial direction, and an annular supporting plate 38 is integrally secured to the lower extension to support the inner cylinder 32. Although not shown, the water-cooled jacket 33 has a water supply port formed in a lower part of the jacket, and a water discharge port formed in an upper part of the jacket to ensure the flowing of a cooling fluid R which is usually water. The cooling fluid R may be circulated.

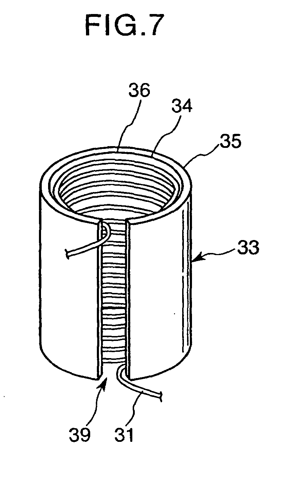

As shown in FIG. 7, the water-cooled jacket 33 may be formed so as to have a slit 39 extending in the axial direction, not in a continuous cylindrical form in the circumferential direction. In this case, it is possible to take out a terminal of the heater 31 installed in the water-cooled jacket 33 by using the slit 39.

The water-cooled jacket 33 is made of a material having a high thermal conductivity such as a metal. In this embodiment, the inner wall 34, the outer wall 35, the upper wall 36 and the lower wall 37 are manufactured with stainless steel plates having a thickness of 3 mm. A gap (G2) of from 8 to 13 mm for arranging the heater 31 is provided between the inner surface of the inner wall 34 of the water-cooled jacket 33 surrounding the inner cylinder 32 and the inner cylinder 32. In this embodiment, in which the inner cylinder 32 has an outside diameter (D3) of 253 mm, the water-cooled jacket 33 has an inside diameter (D4) of 272 mm. The inner wall 34 of the water-cooled jacket 33 has an axial length sufficient to completely cover the heating means 30.

The heating means 30 will be described further. According to the present invention, the heating means 30 has the electric heater 31 as described above, and is spirally wound around the outer periphery of the inner cylinder 32.

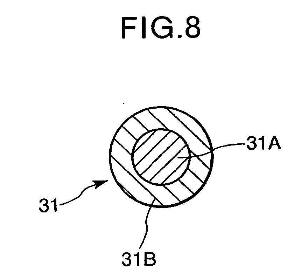

According to the present invention, the electric heater 31 is formed by covering a resistance-heating wire 31A with an electrically insulating tube 31B as shown in FIG. 8. The resistance-heating wire 31A may suitably be made of a nichrome wire or a noble metal non-magnetic heater such as platinum. The electrically insulating tube 31 B is a tube made by knitting fibrous alumina fibers, or connecting a plurality of quartz or alumina tubes. In this embodiment, the resistance-heating wire 31A is prepared by covering a nichrome wire having a diameter of from 2.0 to 2.6 mm with the tube 3 1 B made by knitting alumina fibers, into an outside diameter of 3.5 mm.

The resistance-heating wire 31A, being placed in the magnetic field produced by the magnetic field generating means 20 as described above, is subjected to application of a force resulting from the interaction with the magnetic field caused by the current for heating, leading to contact between resistance wires. Therefore, the resistance-heating wire 31 A should preferably be electrically insulated with the insulating tube 31B.

In order to reduce the force resulting from the interaction, it is desirable to adopt the so-called non-inducing winding in which the flow of current of the resistance-heating wire 31 A is arranged so as to cancel the resultant magnetic field.

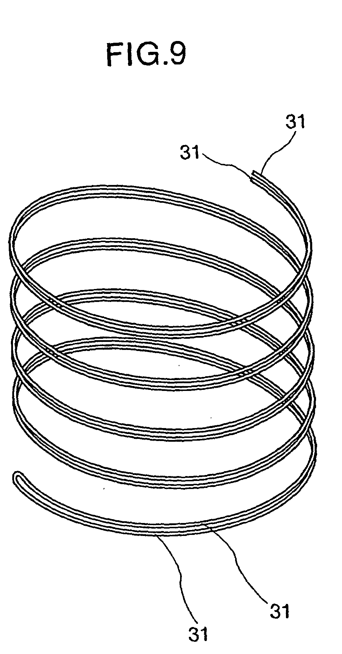

More specifically, as shown in FIG. 9, the heater 31 is wound on the inner cylinder 32 into a single-layer winding in a dual-wire state in which the wire is connected at an end, i.e., in a U shape. Therefore, the directions of the current flowing through the upper and lower resistance-heating wires 31A adjacent to each other in the axial direction are counter to each other. As a result, the magnetic field generated by the current flowing through the resistance-heating wires 31 A set off each other and are cancelled. If the heater 31 is made by merely winding a single wire, the magnetic field from the magnetic field generating means 20, when current flows through the resistance-heating wire 31A, applies a force onto the resistance-heating wire 31A, resulting in a shift or vibration of the heater 31, as stated above.

To ensure stable cancellation of such a force, the heating current should preferably be a direct current. Control means for controlling the temperature is usually provided for the heating means 30 to control the energizing of the heater 31.

Usually, the heat treatment temperature is within a range of from about 150 °C. to 500 °C. When heat-treating a magnetic film having a high ordering temperature of the structure of film, however, the temperature should be within a range of from about 500 °C. to 800 °C. When heat-treating a magnetic film for an MR device, the cooling rate should preferably be at least 5 °C./minute, or particularly, within a range of from 15 °C./minute to 200 °C/minute.

No heat insulating material should preferably be provided around the heater 31. In this embodiment, however, as the water-cooled jacket 33 is made of stainless steel, an alumina sheet 40 (FIG. 6) serving as a sheet-shaped electric insulator should preferably be arranged between the water-cooled jacket 33 and the heater 31. The alumina sheet 40 may have a thickness within a range of from about 1 to 3 mm. The electric insulator in the gap between the heater 31 and the water-cooled jacket 33 should preferably have a thickness of up to 4 mm. The heater 31 may be wound on the inner peripheral surface of the alumina sheet 40 without providing the inner cylinder 32.

The aforementioned heat treatment apparatus 1 further comprises a power source for the magnetic field generating means 20, a magnetic field measuring controller, a control unit for the vacuum pump for evacuating the vacuum vessel 2, and a mechanism for controlling the operating sequence of the overall apparatus. These components may be ones well known by those skilled in the art. Detailed description thereof is therefore omitted here.

While the above description has explained the magnetic field generating means 20 as an electromagnet 21, but it may be a superconducting electromagnet. The heating means 30 has been explained above as being arranged outside the vacuum vessel 2, but as required, it may be installed in the vacuum vessel 2.

The configuration displaying important features of the present invention will now be described.

According to the present invention, as is clear from FIGS. 1 to 4, a treatment chamber 50 capable of being hermetically closed, confining a space communicating with the vacuum vessel 2, is provided in the heat treatment apparatus 1.

In this embodiment, the treatment chamber 50 has a cubic box shape, and is installed above the lower structure 5 housing the vacuum vessel 2, the heating means 30, the magnetic field generating means 20 and the like. Therefore, the vessel attachment section 2B of the vacuum vessel 2 projects from below into the treatment chamber 50, and the vessel attachment section 2B opens into the treatment chamber 50.

According to this embodiment, the vessel attachment section 2B of the vacuum vessel 2, the holder supporting unit 3B, and the lift mechanism 10 serving as the conveying means are arranged in the treatment chamber 50.

Also in this embodiment, an intermediate chamber 70 is arranged adjacent to the treatment chamber 50. The intermediate chamber 70 is a space capable of being hermetically closed for charging or discharging the object of treatment between the treatment chamber 50 and outside. The intermediate chamber 70 shields the outside space and the treatment chamber 50 from each other, and can maintain an atmosphere in the treatment chamber 50 on a constant level without being affected by outside, preferably by achieving a vacuum atmosphere.

Gate valves 71 and 72 capable of being opened and closed are arranged, respectively, on a partition wall between the treatment chamber 50 and the intermediate chamber 70, and on a partition wall between the intermediate chamber 70 and the outside. An index table 73 rotation-driven is arranged in the intermediate chamber 70, and a cassette 74 containing the object of treatment can be positioned, in this embodiment, at any of four positions on the circumference. The index table 73 is vertically movable within the intermediate chamber 70 by means of a cassette elevator 75 comprising an oil hydraulic cylinder.

Handling means, i.e., a handling robot 51 is installed in the treatment chamber 50. By opening the gate valve 71, the handling robot 51 takes out the objects of treatment in the cassette 74 set on the index table 73 one by one in cooperation with the cassette elevator 75 to transfer the same to the tray 6 of the holder 3A supported by the holder supporting unit 3B. Since the handling robot 51 performing such operations is well known by those skilled in the art, a detailed description thereof is omitted here.

According to this embodiment, as shown in FIG. 1, a running device 52 serving as running means is provided in the treatment chamber 50 for the purpose of causing the holder supporting unit 3B and the holder 3A to move from a charging position (A) where the objects of treatment are inserted into the vacuum vessel 2 to a receiving position (B) where the handling robot 51 receives the objects of treatment one by one, or to move from the receiving position (B) to the charging position (A).

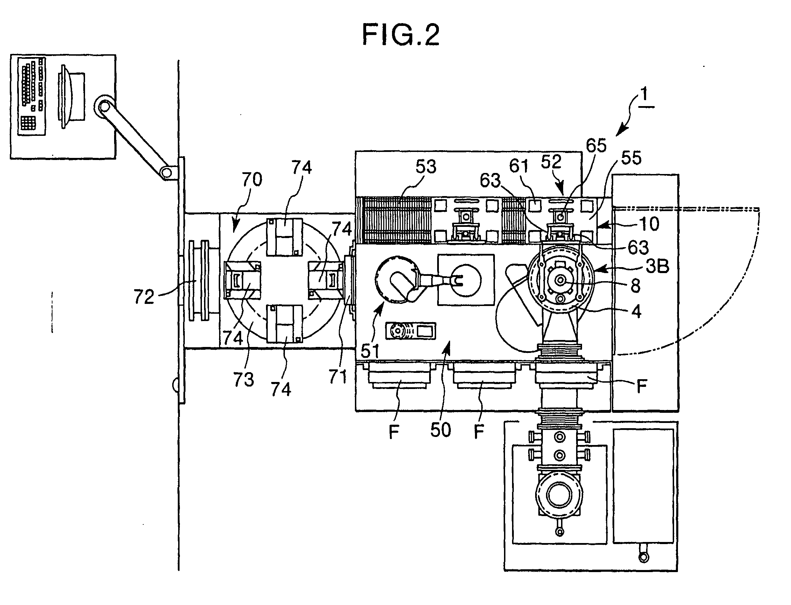

In this embodiment, the running device 52 comprises, as most typically represented in FIGS. 2 and 4, a guide streak 53 provided on the base of the bottom wall of the treatment chamber 50, and a cart 55 having a slider 54 running straight along the guide streak 53. The running device 52, however, can be selected from among various structures. The cart 55 therefore conducts a straight reciprocation along the guide streak 53 by driving driving means (not shown) such as a hydraulic cylinder. As the conveying means, the lift mechanism 10 is attached to the cart 55.

In this embodiment, the lift mechanism 10 comprises a frame structure 61 which is secured to the cart 55 and extends upward, and supporting means 62 for supporting the holder supporting unit 3 B on the frame structure 61.

The supporting means 62 has an end fixed to the holder supporting unit 3B and the other end vertically movably attached to a guide rod 63 installed on the frame structure 61 via a bearing member 64. A parent screw shaft 65 rotation-driven by driving means is installed on the frame structure 61, and screw-engaged with a nut 66 fixed to the supporting means 61. Therefore, the supporting means 62 can be vertically moved relative to the frame structure 61 by driving the parent screw shaft 65 with the driving means.

In the above-mentioned configuration, by driving the cart 55 by the driving means along the guide streak 53, the holder supporting unit 3B and the holder 3A can be moved between the object charging position (A) and the object receiving position (B) as an integral entity. At the object charging position (A), it is possible to insert the holder supporting unit 3B and the holder 3A into the vacuum vessel, or take out the same from the vacuum vessel 2 to outside by driving the lift mechanism 10.

A cassette charging gate valve 72 for installing the cassette in the intermediate chamber 70 is provided in the intermediate chamber 70 as described above. Therefore, an operator can install a cassette containing a prescribed nember of objects of treatment on the index table 73 in the intermediate chamber 70 by opening this cassette charging gate valve 72.

Operation of the heat treatment apparatus having the above-mentioned configuration of this embodiment will now be described.

First, the holder supporting unit 3B and the holder 3A arranged at the charging position (A) are taken out upward from the vacuum vessel 2 by driving the lift mechanism 10. Then, by causing the cart 55 to run by driving the driving means, the holder supporting unit 3B and the holder 3A are stopped at the object receiving position (B) as an integral entity.

By opening the gate valve 71 provided on the partition wall between the treatment chamber 50 and the intermediate chamber 70, the handling robot 51 takes out the objects of treatment one by one in the cassette 74 set onto the index table 73, and transfers the same to the holder 3 A.

Upon the completion of transfer of the objects of treatment to the holder 3A, the gate valve 71 is closed, and the cart 55 is driven to cause the holder supporting unit 3B and the holder 3A to run to the object charging position (A) and to stop there.

Then, the holder supporting unit 3B and the holder 3A are inserted into the vacuum vessel 2 by driving the lift mechanism 10. The opening of the vacuum vessel 2 is closed by a sealing lid 4 provided on the holder supporting unit 3B.

Subsequently, the interior of the vacuum vessel 2 is evacuated to reduce pressure, and the interior of the vacuum vessel 2 is set to contain a nonoxidizing gas atmosphere in the same procedure as in the above-mentioned conventional art. Then, a heat treatment is applied to the object of treatment supported by the holder.

According to the present invention, on the other hand, the treatment chamber 50 becomes hermetically closed while the opening of the vacuum vessel 2 is closed, and is set to contain a prescribed atmosphere.

More specifically, in this embodiment, since the object of treatment is a magnetic material such as an MR film or a GMR film, which is deteriorated by an open-air atmosphere at a treating temperature higher than room temperature, the interior of the treatment chamber 50 is set to contain a nonoxidizing atmosphere of such as nitrogen or argon. Therefore, the interior of the treatment chamber 50, after evacuation to below 1 Pa, is filled with nitrogen gas in this embodiment to achieve a nitrogen gas atmosphere at room temperature under a pressure of 1 atm (0.1 MPa). Alternatively, the interior of the treatment chamber 50 may be left in vacuum state. As the condition of atmosphere in the treatment chamber 50, a desired gas, a desired chamber temperature, a desired pressure and the like may be selected as required.

After achieving the nonoxidizing atmosphere state in the treatment chamber 50, the vacuum state in the vacuum vessel 2 is released by injecting nitrogen gas into the vacuum vessel 2 via a valve 10a, and the holder supporting unit 3B and the holder 3A are lifted up from the opening of the vacuum vessel by driving the lift mechanism 10.

The interior of the treatment chamber 50 is kept in a nonoxidizing atmosphere state at room temperature. As a result, the heat-treated object of treatment is rapidly cooled without suffering from deterioration.

According to the result of an experiment carried out by the present inventors, it took a time of about 25 minutes for an object of treatment heated to about 500 °C to 800 °C to be cooled to 50 °C. As compared with the conventionally required time of from 3 to 4 hours, the cooling period could remarkably be reduced. Further, physical properties of the object of treatment showed no change.

Thereafter, as described above, the cart 55 is caused to run by driving it with the driving means. The holder supporting unit 3B and the holder 3A are moved as an integral entity to the object receiving position (B). The treated objects supported by the holder 3A are transferred to the intermediate chamber 70 by means of the handling robot 51. Then, the objects of treatment housed in the cassette 74 to be treated next, set in the intermediate chamber 70, are transferred to the holder 3A.

Subsequently, treatment operation for the next batch is started in the above-mentioned procedure.

According to the present invention, as described above, it is possible to largely curtail the treatment time for a batch.

Furthermore, in order to reduce the cooling time and remarkably reduce the treatment time for a batch, the atmosphere gas in the treatment chamber 50 can be circulated in the treatment chamber 50. It is also possible to draw out the atmosphere gas to outside the treatment chamber 50 via a duct (not shown), cool the gas, and then reflux the gas again into the treatment chamber 50 through a filter F (FIG. 2) to avoid mixing of dust. In all cases, direct blowing of the atmosphere gas onto the object of treatment permits further acceleration of the cooling rate.

### Second Embodiment

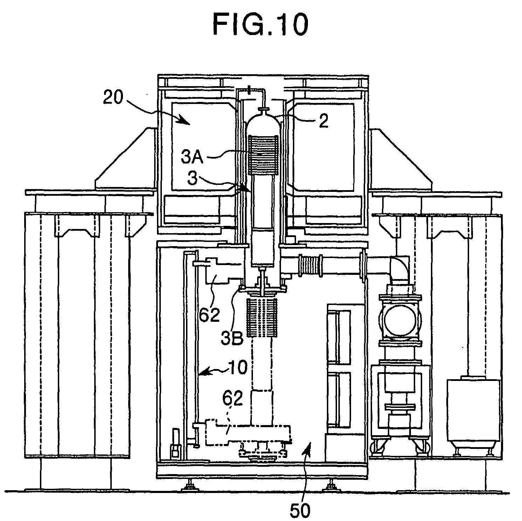

In the first embodiment, the description has been based on a configuration in which the treatment chamber 50 is located above the vacuum vessel 2, and the object of treatment travels between the heat treatment vessel 2 and the treatment chamber 50 by moving the same vertically via the holder supporting unit 3B and the holder 3A by means of the conveying means 10. In this embodiment, in contrast, as shown in FIG. 10, the treatment chamber 50 is located below the vacuum vessel 2, and the object of treatment is movable between the heat treatment vessel 2 and the treatment chamber 50 by vertically moving the same via the holder supporting unit 3B and the holder 3A by means of the conveying means 10 as in the first embodiment.

Also in this embodiment, the same functional effects as in the first embodiment are available, and furthermore, in this embodiment, since the conveying means 10 and the like for moving the object of treatment are arranged below the vacuum vessel 2, there is available an advantage that dust is hard to adhere to the object of treatment. Particularly, the configuration in which the treatment chamber 58 is a dust-free chamber will be described further in detail in a fourth embodiment.

### Third Embodiment

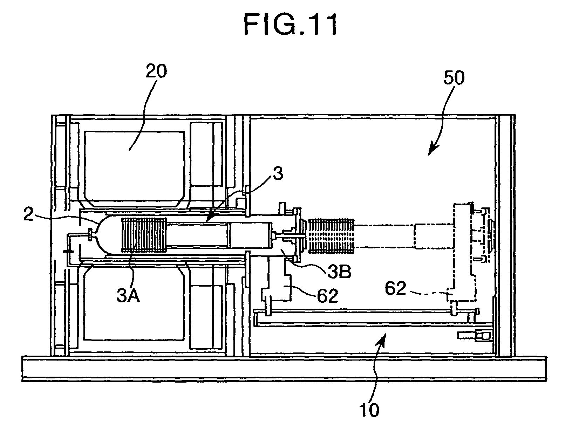

Unlike the first and the second embodiments, this embodiment has a configuration in which, as shown in FIG. 11, the vacuum vessel 2 is horizontally arranged, and the treatment chamber 50 is positioned on a side of the vacuum vessel 2.

In this embodiment, the object of treatment travels between the heat treatment vessel 2 and the treatment chamber 50 through horizontal displacement via the holder supporting unit 3B and the holder 3A by the conveying means 10.

Also in this embodiment, there are available the same functional effects as in the first embodiment.

### Fourth Embodiment

In this embodiment, a heat treatment apparatus and a heat treatment method have a configuration such that the treatment chamber 50 serving as a dust-free chamber is located below the vacuum vessel 2 as described in the second embodiment, to make it difficult for dust to adhere to the object of treatment. The heat treatment apparatus and the heat treatment method of this embodiment will now be described further in detail with reference to the drawings.

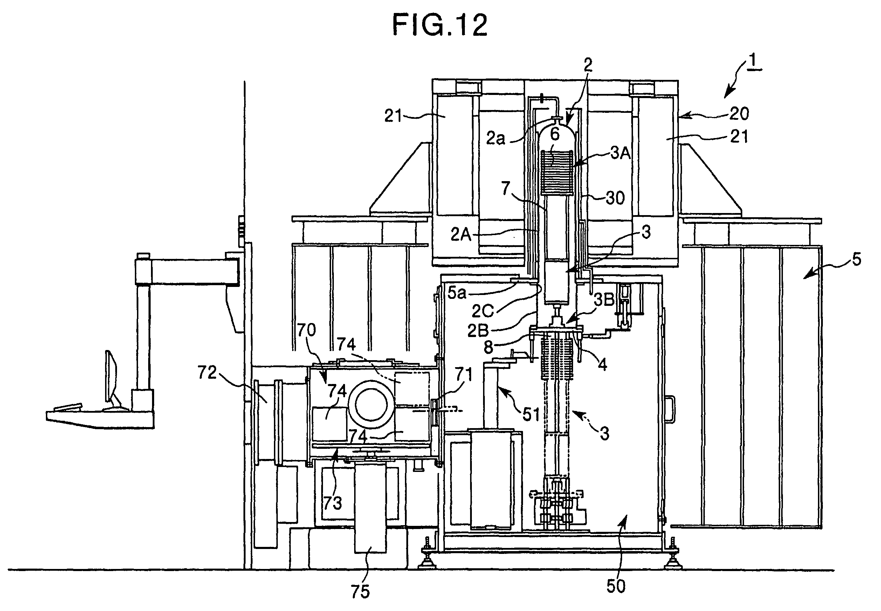

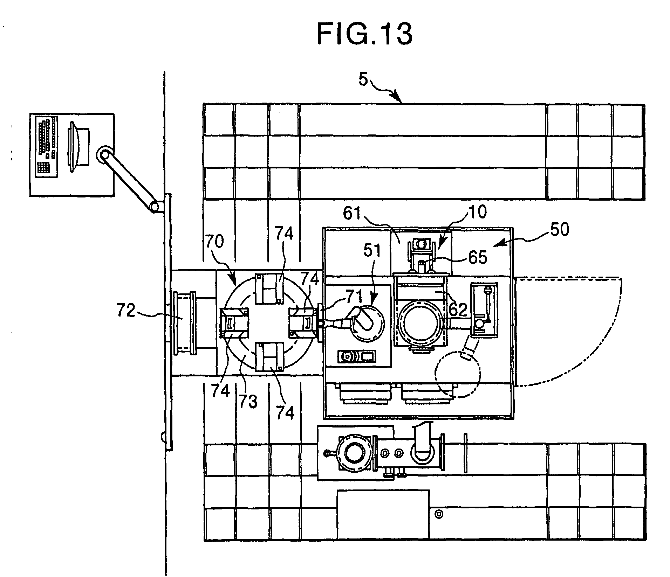

FIGS. 12 to 14 illustrate a schematic overall configuration of the heat treatment apparatus 1 of this embodiment.

According to this embodiment, the heat treatment apparatus 1 has a vacuum vessel 2 serving as a heat treatment vessel, holding means 3 which holds an object of treatment in the vacuum vessel 2, and magnetic field generating means 20 arranged outside the vacuum vessel 2, as in the conventional treatment apparatus 1A. The holding means 3 has a holder 3A which holds the object of treatment, and a holder supporting unit 3B which supports this holder 3A. In the heat treatment apparatus 1 of this embodiment, an opening of the vacuum vessel 2 is formed at the lower end thereof. The holder supporting unit 3B is therefore arranged below the vacuum vessel 2.

In this embodiment, more particularly, the vacuum vessel 2 is a stepped cylindrical container comprising a vessel main body 2A having a smaller diameter, and a vessel attachment section 2B having a larger diameter formed integrally with the lower portion of the vessel main body 2A. In this embodiment, the upper end of the vessel main body 2A is connected to a conduit for introducing a nonoxidizing gas via a valve 2a. However, the upper end of the vessel main body 2A is substantially a closed end, and the lower end of the vessel attachment section 2B is open.

In this embodiment, the lower end of the vessel is closely sealed by attaching a lid member 4 of the holder supporting unit 3B to the opening at the lower end of the vessel. Further, an annular shoulder 2C formed between the vessel main body 2A and the vessel attachment section 2B of the vacuum vessel 2 is mounted on a vessel placing section 5a of a dust-free chamber 50 forming a lower structure 5, and the vacuum vessel 2 is held there.

The vacuum vessel 2 should preferably be made of ceramics such as quartz glass for its stability during rapid cooling. In this embodiment, as described later in detail, heating in vacuum by heating means 30 is accomplished mainly by radiation heat as in the preceding embodiment. The quartz glass should therefore preferably be an optically transparent one. The vacuum vessel 2, which may have a thickness within a range of from 2 to 6 mm, has a thickness of 3 mm in this embodiment.

The holder 3A comprises about 30 trays 6 for mounting a substrate having a diameter of from about 100 to 200 mm and having, for example an Fe-Ni alloy film formed by sputtering. The trays 6 are supported by a supporting shaft body 7, the lower end of which is connected to, and supported by, the holder supporting unit 3B.

The holder supporting unit 3B should preferably rotatably hold the holder 3A so that the direction of the object of treatment held by the holder 3A can be changed relative to the magnetic field direction. In this embodiment, therefore, a driving motor 8 is attached to the holder supporting unit 3B so that the supporting shaft body 7 of the holder 3A can be rotation-driven.

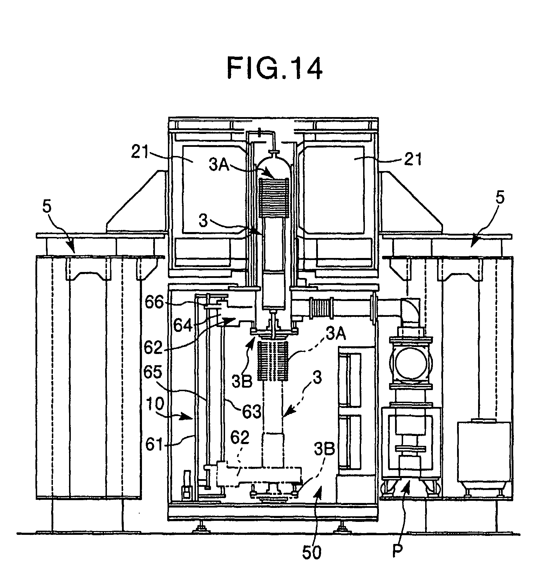

The vacuum vessel 2 can be maintained in a prescribed vacuum state by evacuating the interior of the vacuum vessel 2 by means of a vacuum pump P (see FIG. 14) communicating with the lower end of the vacuum vessel, after attaching the holder supporting unit 3B to the lower end of the vacuum vessel. For example, when the object of treatment is a magnetic metal thin film, the object of treatment should preferably be heat-treated in vacuum, or more specifically, in a vacuum of up to 1 Pa to avoid oxidation of the metal thin film. Or preferably, a prescribed atmosphere should be contained in the vacuum vessel 2. In this embodiment, a nonoxidizing gas atmosphere is achieved in the vacuum vessel 2 by filling the vacuum vessel 2 with a nonoxidizing gas such as nitrogen gas or argon gas.

As is well understood by referring to FIG. 14, the holder supporting unit 3B is arranged at the lower end of the vessel. The holder 3A can be moved, together with the holder supporting unit 3B, by a lift mechanism 10 serving as conveying means downward outside the vessel 2. In this state, therefore, it is possible to mount the object to be heat-treated such as a magnetic material onto the holder 3A, or remove the same from the holder 3A. The lift mechanism 10 serving as the conveying means will be described later in detail.

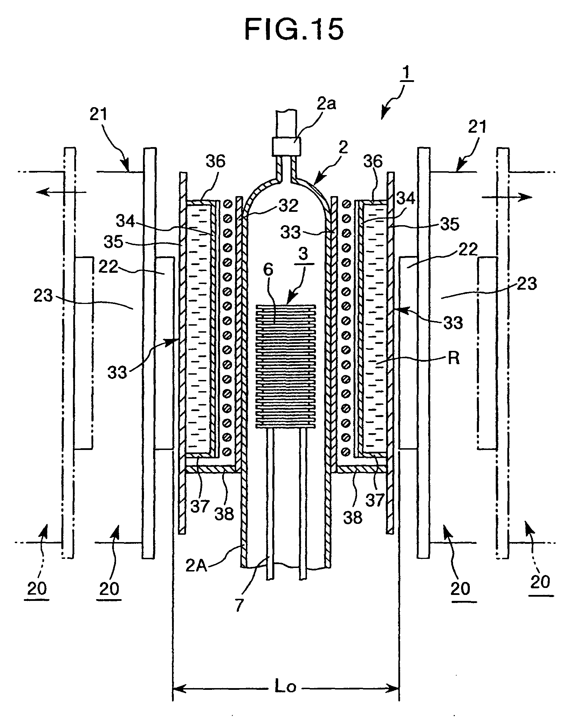

The magnetic field generating means 20 is provided with a pair of electromagnets 21 oppositely arranged, and each electromagnet 21 has, as showin in FIG. 15, a magnetic core 22 and a coil 23. According to this embodiment, as described later in detail, the heating means 30 arranged between the vacuum vessel 2 and the magnetic core 22 may have a smaller thickness, and it is therefore possible to reduce the distance between the magnetic cores 22 and 22 of the electromagnets 21 in pair. Therefore, the electromagnet 21 itself can be downsized. According to this embodiment, furthermore, since the magnetic core 22 is not heated, low thermal resistance materials can be used. In this embodiment, therefore, it is possible to use a magnetic field density produced with the magnetic field generating means 20 of at least 0.05 tesla, or particularly, within a range of from about 0.1 to 5 tesla. In this embodiment, the distance (LO) between the magnetic cores 22 (see FIG. 15) is 300 mm.

This embodiment has substantially the same configuration as in the first embodiment, and as is understood by referring also to FIG. 6, the thin-shaped heating means 30 is provided between the outer surface of the vessel main body 2A of the vacuum vessel 2 and the end face of the magnetic core 22 of the electromagnet 21. There is provided an electric heater 31 based on electric-resistance heating as the heating means 30. The heating means is not limited to this. Such heating means 30 is preferable as compared with induction heating means requiring an expensive power source because of the low cost.

More specifically, the heating means 30 has an electrically insulating inner cylinder 32 arranged so as to surround the outer periphery of the vacuum vessel main body 2A, and a water-cooled jacket forming a fluid cooling section 33 spaced apart from the inner cylinder 32 by a prescribed distance. The inner cylinder 32 can be manufactured from a quartz glass tube having a thickness of from 2 to 6 mm. A gap (G1) of from 2 to 4 mm is provided between the inner cylinder 32 and the outer periphery of the vacuum vessel main body 2A. In this embodiment, in which the vacuum vessel main body 2A has an outside diameter (D1) of 240 mm, the inner cylinder 32 has an inside diameter (D2) of 245 mm. The inner cylinder 32 has an axial length (L1) of 450 mm.

The water-cooled jacket 33 is a cylinder having a dual tube structure with an inner wall 34 and an outer wall 35, and the upper end and the lower end thereof are closed by an upper wall 36 and a lower wall 37, respectively. In this embodiment, as shown in FIG. 15, the outer wall 35 is extended below the lower wall 37 in the axial direction, and an annular supporting plate 38 is integrally secured to the lower extension to support the inner cylinder 32. Although not shown, the water-cooled jacket 33 has a water supply port formed in a lower part of the jacket, and a water discharge port formed in an upper part of the jacket to ensure the flowing of a cooling fluid R which is usually water. The cooling fluid R may be circulated.

A water-cooled jacket having the same configuration as that in the first embodiment may be used as the water-cooled jacket 33, and as shown in FIG. 7, may be formed so as to have a slit 39 extending in the axial direction, not in a continuous cylindrical form in the circumferential direction. In this case, it is possible to take out a terminal of the heater 31 installed in the water-cooled jacket 33 by using the slit 39.

The water-cooled jacket 33 is made of a material having a high thermal conductivity such as a metal. In this embodiment, the inner wall 34, the outer wall 35, the upper wall 36 and the lower wall 37 are manufactured with stainless steel plates having a thickness of 3 mm. A gasp (G2) of from 8 to 13 mm for arranging the heater 31 is provided between the inner surface of the inner wall 34 of the water-cooled jacket 33 surrounding the inner cylinder 32 and the inner cylinder 32. In this embodiment, in which the inner cylinder 32 has an outside diameter (D3) of 253 mm, the water-cooled jacket 33 has an inside diameter (D4) of 272 mm. The inner wall 34 of the water-cooled jacket 33 has an axial length sufficient to completely cover the heating means 30.

The heating means 30 will be described further. According to the present invention, the heating means 30 has the electric heater 31 as described above, and is spirally wound around the outer periphery of the inner cylinder 32.

According to the present invention, the electric heater 31 is formed by covering a resistance-heating wire 31 A with an electrically insulating tube 31B as shown in FIG. 8. The resistance-heating wire 31A may suitably be made of a nichrome wire or a noble metal non-magnetic heater such as platinum. The electrically insulating tube 31 B is a tube made by knitting fibrous alumina fibers, or connecting a plurality of quartz or alumina tubes. In this embodiment, the resistance-heating wire 31A is prepared by covering a nichrome wire having a diameter of from 2.0 to 2.6 mm with the tube 31B made by knitting alumina fibers, into an outside diameter of 3.5 mm.

The resistance-heating wire 31A, being placed in the magnetic field produced by the magnetic field generating means 20 as described above, is subjected to application of a force resulting from the interaction with the magnetic field caused by the current for heating, leading to contact between resistance wires. Therefore, the resistance-heating wire 31A should preferably be electrically insulated with the insulating tube 31B.

In order to reduce the force resulting from the interaction, it is desirable to adopt the so-called non-inducing winding in which the flow of the current of the resistance-heating wire 31 A is arranged so as to cancel the resultant magnetic field.

More specifically, as shown in FIG. 9, the heater 31 is wound on the inner cylinder 32 into a single-layer winding in a dual-wire state in which the wire is connected at an end, i.e., in a U shape. Therefore, the directions of the current flowing through the upper and lower resistance-heating wires 31A adjacent to each other in the axial direction are counter to each other. As a result, the magnetic field generated by the current flowing through the resistance-heating wires 31 A set off each other and are cancelled. If the heater 31 is made by merely winding a single wire, the magnetic field from the magnetic field generating means 20, when current flows through the resistance-heating wire 31A, applies a force onto the resistance-heating wire 31A, resulting in a shift or vibration of the heater 31, as stated above.

To ensure stable cancellation of such a force, the heating current should preferably be a direct current. Control means for controlling the temperature is usually provided for the heating means 30 to control the energizing of the heater 31.

Usually, the heat treatment temperature is within a range of from about 150 °C. to 500 °C. When heat-treating a magnetic film having a high ordering temperature of the structure of film, however, the temperature should be within a range of from about 500 °C. to 800 °C. When heat-treating a magnetic film for an MR device, the cooling rate should preferably be at least 5 °C./minute, or preferably, within a range of from 15 °C./minute to 200 °C./minute.

No heat insulating material should preferably be provided around the heater 31. In this embodiment, however, as the water-cooled jacket 33 is made of stainless steel, an alumina sheet 40 (FIG. 6) serving as a sheet-shaped electric insulator should preferably be arranged between the water-cooled jacket 33 and the heater 31. The alumina sheet 40 may have a thickness within a range of from about 1 to 3 mm. The electric insulator in the gap between the heater 31 and the water-cooled jacket 33 should preferably have a thickness of up to 4 mm. The heater 31 may be wound on the inner peripheral surface of the alumina sheet 40 without providing the inner cylinder 2.

The aforementioned heat treatment apparatus 1 further comprises a power source for the magnetic field generating means 20, a magnetic field measuring controller, a control unit for the vacuum pump for evacuating the vacuum vessel 2, and a mechanism for controlling the operating sequence of the overall apparatus. These components may be ones well known by those skilled in the art. Detailed description thereof is therefore omitted here.

While the above description has explained the magnetic field generating means 20 as an electromagnet 21, but it may be a superconducting electromagnet. The heating means 30 has been explained above as being arranged outside the vacuum vessel 2, but as required, it may be installed in the vacuum vessel 2.

The configuration displaying important features of the present invention will now be described.

According to the present invention, the dust-free chamber 50 capable of being hermetically closed, confining a dust-free space communicating with the lower opening of the vacuum vessel 2, which serves also as a treatment chamber, is provided in the heat treatment apparatus 1. In this embodiment, the electromagnet 21 and the like arranged to surround the vacuum vessel 2 high in weight are not installed on the dust-free chamber 50, but attached to a base structure 5 installed to surround the dust-free chamber 50.

In this embodiment, the dust-free chamber 50 has a cubic box shape, and is installed below the vacuum vessel 2, the heating means 30, the magnetic field generating means 20 and the like. Therefore, the vessel attachment section 2B of the vacuum vessel 2 projects downward into the dust-free chamber 50, and the opening of the vessel attachment section 2B opens into the dust-free chamber 50.

According to this embodiment, the vessel attachment section 2B of the vacuum vessel 2, the holder supporting unit 3B, and the lift mechanism 10 serving as the conveying means are arranged in the dust-free chamber 50.

Also in this embodiment, an intermediate chamber 70 is arranged adjacent to the dust-free chamber 50. The intermediate chamber 70 is a space capable of being hermetically closed for charging or discharging the object of treatment between the dust-free chamber 50 and outside. The intermediate chamber 70 shields the outside space and the dust-free chamber 50 from each other, and can maintain an atmosphere in the dust-free chamber 50 on a constant level without being affected by outside, preferably by achieving a vacuum atmosphere.

Gate valves 71 and 72 capable of being opened and closed are arranged, respectively, on a partition wall between the dust-free chamber 50 and the intermediate chamber 70, and on a partition wall between the intermediate chamber 70 and the outside. An index table 73 rotation-driven is arranged in the intermediate chamber 70, and a cassette 74 containing the object of treatment can be positioned, in this embodiment, at any of four positions on the circumference. The index table 73 is vertically movable within the intermediate chamber 70 by means of a cassette elevator 75 comprising an oil hydraulic cylinder.

Handling means, i.e., a handling robot 51 is installed in the dust-free chamber 50. By opening the gate valve 71, the handling robot 5 1 takes out the objects of treatment in the cassette 74 set on the index table 73 one by one in cooperation with the cassette elevator 75 to transfer the same to the tray 6 of the holder 3A supported by the holder supporting unit 3B. Since the handling robot 51 performing such operations is well known by those skilled in the art, a detailed description thereof is omitted here.

In this embodiment, as will be understood more clearly by referring to FIGS. 12 to 14, the lift mechanism 10 comprises a frame structure 61 which is secured to the bottom wall of the dust-free chamber 50 and extends upward, and supporting means 62 for supporting the holder supporting unit 3B on the frame structure 61.

The supporting means 62 has an end fixed to the holder supporting unit 3B and the other end vertically movably attached to a guide rod 63 installed on the frame structure 61 via a bearing member 64. A parent screw shaft 65 rotation-driven by driving means is installed on the frame structure 61, and screw-engaged with a nut 66 fixed to the supporting means 62. Therefore, the supporting means 62 can be vertically moved relative to the frame structure 61 by driving the parent screw shaft 65 with the driving means.

In the above-mentioned configuration, it is possible to insert the holder supporting unit 3B and the holder 3A into the vacuum vessel 2, or take out the same from the vacuum vessel 2 to outside by driving the lift mechanism 10.

A cassette charging gate valve 72 for installing the cassette in the intermediate chamber 70 is provided in the intermediate chamber 70 as described above. Therefore, an operator can install a cassette containing a prescribed number of objects of treatment on the index table 73 in the intermediate chamber 70 by opening this cassette charging gate valve 72.

Operation of the heat treatment apparatus having the above-mentioned configuration of this embodiment will now be described.

First, the holder supporting unit 3B and the holder 3A are moved downward from the interior of the vacuum vessel 2 by driving the lift mechanism 10 to expose the same outside the vacuum vessel 2.

By opening the gate valve 71 provided on the partition wall between the dust-free chamber 50 and the intermediate chamber 70, the handling robot 51 takes out the objects of treatment one by one in the cassette 74 set on the index table 73, and transfers the same to the holder 3A.

Upon the completion of transfer of the objects of treatment to the holder 3A, the gate valve 71 is closed.

Then, the holder supporting unit 3B and the holder 3A are inserted from below into the vacuum vessel 2 above by driving the lift mechanism 10. The opening of the vacuum vessel 2 is closed by a sealing lid 4 provided on the holder supporting unit 3B.

Subsequently, the interior of the vacuum vessel 2 is evacuated to reduce pressure, and the interior of the vacuum vessel 2 is set to contain a nonoxidizing gas atmosphere in the same procedure as in the above-mentioned conventional art. Then, a heat treatment is applied to the object of treatment supported by the holder 3A.

According to this embodiment, on the other hand, the dust-free chamber 50 serves also as the treatment chamber described in the preceding embodiment, becomes hermetically closed while the opening of the vacuum vessel 2 is closed, into a vacuum state. It is set to contain a prescribed atmosphere as required.

More specifically, in this embodiment, since the object of treatment is a magnetic material such as an MR film or a GMR film, which is deteriorated by an open-air atmosphere at a treating temperature higher than room temperature, the interior of the dust-free chamber 50 is set to contain a nonoxidizing atmosphere of such as nitrogen or argon. Therefore, the interior of the dust-free chamber 50, after evacuation to below 1 Pa, is filled with nitrogen gas in this embodiment to achieve a nitrogen gas atmosphere at room temperature under a pressure of 1 atm (0.1 MPa). Alternatively, the interior of the dust-free chamber 50 may be left in the vacuum state. As the condition of atmosphere in the dust-free chamber 50, a desired gas, a desired chamber temperature, a desired pressure and the like may be selected as required.

After achieving the nonoxidizing atmosphere state in the dust-free chamber 50, the vacuum state in the vacuum vessel 2 is released by injecting nitrogen gas into the vacuum vessel 2 via the valve 10a, and the holder supporting unit 3B and the holder 3A are lowered from the lower-end opening of the vacuum vessel by driving the lift mechanism 10.

The interior of the dust-free chamber 50 is kept in a nonoxidizing atmosphere state at room temperature, thus permitting rapid cooling the heat-treated object of treatment without suffering from deterioration.

Thereafter, the treated objects supported by the holder 3A are transferred to the intermediate chamber 70 by means of the handling robot 51. Then, the objects of treatment housed in the cassette to be treated next, set in the intermediate chamber 70, are transferred to the holder 3A.

Subsequently, treatment operation for the next batch is started in the above-mentioned procedure.

According to this embodiment, as described above, the dust-free chamber 50 is provided below the heat treatment vessel such as the vacuum vessel 2. In addition, at least the movable portion of the conveying means 10 for moving the object of treatment is arranged below the vacuum vessel 2, or more preferably below the object of treatment. Therefore, the movable portion of the conveying means 10 which is a source of dust, can be arranged below the object of treatment, thus permitting remarkable decrease in adhesion of dust to the object of treatment as compared with the conventional apparatus.

In this configuration, the movable portion of the conveying means 10 which is a source of dust, is arranged below the vacuum vessel 2, or more particularly below the object of treatment. This leads to a higher degree of freedom for the arrangement of the conveying means 10 and the like, thereby permitting setting the same at an arbitrary position in the heat treatment apparatus 1, and reduction of size. It is therefore possible to reduce the installation space of the entire heat treatment apparatus and to improve the degree of freedom of the apparatus layout.

Furthermore, in order to reduce the cooling time and remarkably reduce the treatment time for a batch, the atmosphere gas in the dust-free chamber 50 can be circulated in the dust-free chamber 50. It is also possible to draw out the atmosphere gas to outside the dust-free chamber 50 via a duct, cool the gas, and then reflux the gas again into the dust-free chamber 50 through a filter to avoid mixing of dust. In all cases, direct blowing of the atmosphere gas onto the object of treatment permits further acceleration of the cooling rate.

In the above-mentioned embodiment, the electromagnet 21, the heating means 30, the water-cooled jacket 33 and the like, which are disposed around the vacuum vessel 2, are attached to the base structure 5 installed around the dust-free chamber 50. Therefore, by adopting a divisible structure at least for the electromagnet 21, or preferably, the heating means 30, the fluid cooling section 33 and the like, it is possible to cause divisional displacement of the electromagnet 21, the heating means 30, the water-cooled jacket 33 and the like after the heat-treating step, as shown by a one-point chain line in FIG. 15, and to separate them from the heat treatment vessel 2. Accordingly, it is also possible to very easily accomplish cooling the heat treatment vessel 2. After the completion of cooling of the heat treatment vessel, these components 21, 30, 33 and the like are moved to return to prescribed positions relative to the heat treatment vessel 2.

### Industrial Applicability

According to an embodiment of the present invention, as described above, the heat treatment apparatus comprises: a treatment chamber, arranged adjacent to the heat treatment vessel, for which an internal space can be set to contain a prescribed atmosphere; and conveying means which causes the object of treatment to move between the heat treatment vessel and the treatment chamber. It is possible to convey the heat-treated object of treatment to the treatment chamber set to contain a prescribed atmosphere, and rapidly cool the object. It is therefore possible to reduce the treatment period for one batch, and increase the throughput of objects of treatment.

According to another embodiment of the present invention, the heat treatment apparatus comprises: a dust-free chamber, arranged below the heat treatment vessel, in which an opening formed at the lower end of the heat treatment vessel opens; and conveying means, arranged in the dust-free chamber, which acts on the holding means which holds the object of treatment to cause the object of treatment to move between the heat treatment vessel and the dust-free chamber. It is possible to charge the object of treatment into the heat treatment vessel from below to carry out a heat treatment in a magnetic field, and to take out the heat-treated object of treatment from the heat treatment vessel by conveying the same downward into the dust-free chamber. There are therefore available the following advantages:
(1) Dust hardly adheres to the object of treatment; and
(2) The apparatus installation space can be reduced and the degree of freedom for apparatus layout can be improved.

## Claims

1. A heat treatment apparatus comprising holding means which holds an object of treatment, a heat treatment vessel which houses the object of treatment held by said holding means, heating means which heats the object of treatment, and magnetic field generating means which impresses a magnetic field onto the object of treatment, wherein the heat treatment apparatus further comprises:
a treatment chamber, arranged adjacent to said heat treatment vessel, in which an internal space can be set to contain a prescribed atmosphere; and
conveying means which acts on said holding means to cause the object of treatment to move between said heat treatment vessel and said treatment chamber.

2. The heat treatment apparatus according to claim 1, wherein the object of treatment is deteriorated in an open-air atmosphere at a heat treatment temperature, and said treatment chamber is set to contain a nonoxidizing atmosphere.

3. The heat treatment apparatus according to claim 2, wherein the nonoxidizing atmosphere in said treatment chamber is a nitrogen gas or an argon gas atmosphere, or in vacuum.

4. The heat treatment apparatus according to claim 2 or 3, wherein said treatment chamber is set at a prescribed temperature.

5. The heat treatment apparatus according to claim 4, wherein the prescribed temperature of said treatment chamber is the room temperature.

6. The heat treatment apparatus according to any one of claims 1 to 5, wherein said heating means and said magnetic field generating means are arranged so as to surround said heat treatment vessel.

7. The heat treatment apparatus according to any one of claims 1 to 6, wherein said treatment chamber is arranged above, below, or on one side of said heat treatment vessel.

8. A heat treatment method for heat-treating an object of treatment in a magnetic field by using the heat treatment apparatus according to claim 1 comprises:
(a) a step of housing the object of treatment in said heat treatment vessel;
(b) a step of setting the interior of said heat treatment vessel to contain a prescribed atmosphere to carry out the heat treatment in the magnetic field; and
(c) a step of conveying the heat-treated object of treatment to said treatment chamber set to contain a prescribed atmosphere.

9. The heat treatment method according to claim 8, wherein the object of treatment is deteriorated in an open-air atmosphere at a heat treatment temperature, and said treatment chamber is set to contain a nonoxidizing atmosphere.

10. The heat treatment method according to claim 9, wherein the nonoxidizing atmosphere in said treatment chamber is nitrogen gas or argon gas atmosphere, or in vacuum.

11. The heat treatment method according to claim 9 or 10, wherein said treatment chamber is set at a prescribed temperature.

12. The heat treatment method according to claim 11, wherein the prescribed temperature of said treatment chamber is the room temperature.

13. The heat treatment method according to any one of claims 8 to 12, wherein said treatment chamber is arranged above, below or on one side of said heat treatment vessel.

14. A heat treatment apparatus comprising holding means which holds an object of treatment, a heat treatment vessel which houses the object of treatment held by said holding means, heating means which heats the object of treatment, and magnetic field generating means which impresses a magnetic field on the object of treatment, wherein the heat treatment apparatus further comprises:
a dust-free chamber, arranged below said heat treatment vessel, in which an opening formed at the lower end of said heat treatment vessel opens; and
conveying means, arranged in said dust-free chamber, which acts on said holding means to cause the object of treatment to move between said heat treatment vessel and said dust-free chamber.

15. The heat treatment apparatus according to claim 14, wherein said heat treatment vessel is a vacuum vessel evacuated by closing an opening, and said conveying means is arranged at a position below the opening of said vacuum vessel.

16. The heat treatment apparatus according to claim 14, wherein said conveying means has a movable portion positioned below the object of treatment arranged in said dust-free chamber.

17. The heat treatment apparatus according to any one of claims 14 to 16, wherein said heating means and said magnetic field generating means are arranged so as to surround said heat treatment vessel.

18. The heat treatment apparatus according to any one of claims 14 to 17, wherein at least said magnetic field generating means is separable from said heat treatment vessel.

19. A heat treatment method for heat-treating an object of treatment in a magnetic field by using the heat treatment apparatus according to claim 14 comprises:
(a) a step of housing the object of treatment in said holding means;
(b) a step of charging the object of treatment into said heat treatment vessel from below to carry out the heat treatment in the magnetic field; and
(c) a step of taking out the heat-treated object of treatment from said heat treatment vessel by conveying the same downward into said dust-free chamber.
